# FASCICULE DE BREVET EUROPEEN

(11) **EP 3 024 037 B1**
(45) Date de publication et mention de la délivrance du brevet: **13.05.2020**
(21) Numéro de dépôt: 15194366.9
(22) Date de dépôt: 12.11.2015
(51) Int. Cl.: H01L 33/06, H01L 33/32

(54) **DIODE ÉLECTROLUMINESCENTE À PUITS QUANTIQUES DOPÉS ET PROCÉDÉ DE FABRICATION ASSOCIÉ**
LEUCHTDIODE MIT DOTIERTEN QUANTENTÖPFEN UND VERFAHREN ZUR HERSTELLUNG DERSELBEN
LIGHT EMITTING DIODE WITH DOPED QUANTUM WELLS AND CORRESPONDING METHOD OF FABRICATION

(30) Priorité: 19.11.2014 FR 1461201
(43) Date de publication de la demande: 25.05.2016
(73) Titulaire: Commissariat à l'Énergie Atomique et aux Énergies Alternatives, 75015 Paris (FR)
(72) Inventeur: ROBIN, Ivan-Christophe, 38000 GRENOBLE (FR)
(74) Mandataire: Brevalex

(56) Documents cités:
- WO-A1-2014/154690
- WO-A2-2006/035852
- US-A1- 2002 053 676
- US-A1- 2007 278 474
- US-A1- 2010 148 150
- US-A1- 2013 001 637

## Description

### DOMAINE TECHNIQUE

Le domaine de l'invention est celui des diodes électroluminescentes (appelées DELs ou LEDs), ainsi que celui des dispositifs émissifs lumineux à base de telles LEDs (écrans, projecteurs, murs d'images, etc.).

### ÉTAT DE LA TECHNIQUE ANTÉRIEURE

La technique utilisée actuellement pour fabriquer des LEDs à base de semi-conducteurs consiste à réaliser une jonction p-n, c'est-à-dire mettre en contact électriquement un semi-conducteur dopé p avec un semi-conducteur dopé n, avec, entre ces semi-conducteurs dopés p et n, une région intrinsèque, c'est-à-dire non intentionnellement dopée. Une zone de déplétion est alors obtenue au niveau de la jonction p-n. En faisant passer un courant électrique dans cette structure, des recombinaisons radiatives de charges (électrons et trous) sont alors obtenues au niveau de la zone de déplétion, entrainant une émission lumineuse.

Les matériaux à base de GaN (GaN, InGaN, AIGaN) sont les matériaux actuellement utilisés commercialement pour réaliser des LEDs dans l'UV, le bleu, le vert voire le rouge pour des LEDs sous la forme de nanofils. Effectivement, l'énergie de bande interdite du GaN, de 3.42 eV à température ambiante permet d'obtenir de l'émission UV. En ajoutant de l'indium au GaN pour former l'alliage InGaN, l'énergie de la bande interdite est abaissée ce qui permet de décaler les longueurs d'onde d'émission dans le visible.

Afin augmenter l'efficacité d'émission radiative d'une LED, des puits quantiques (QW pour *Quantum Well)* sont couramment réalisés dans la région intrinsèque. Ceci permet de confiner les charges dans les puits quantiques et d'éviter que ces charges soient perdues sur des défauts non radiatifs. Dans les techniques les plus couramment utilisées, l'émission est obtenue à partir de puits quantiques d'alliage InGaN avec 5 à 30% d'indium émettant dans le bleu et jusque dans le rouge.

Toutefois, la différence de mobilité entre les électrons et les trous a tendance à imposer une recombinaison plus proche de la région de semi-conducteur dopé p, voire même dans cette région dopée p, entraînant une efficacité d'émission radiative limitée.

Pour contourner cette difficulté, une méthode consiste à confiner les électrons dans la région intrinsèque au moyen d'une couche de blocage d'électrons (EBL pour *Electron Blocking Layer)* interposée entre la région intrinsèque et la région de semi-conducteur dopé p. On évite de la sorte que les recombinaisons ait lieu en dehors de la région intrinsèque et on augmente ainsi le taux de recombinaisons radiatives. Cette couche de blocage d'électrons est généralement réalisée en AIGaN avec 8 à 20% d'aluminium.

La réalisation de cette couche de blocage d'électrons vient toutefois complexifier la fabrication de la diode. Cette réalisation nécessite en effet une optimisation et une calibration du flux d'aluminium en plus de celles des flux de gallium et d'indium. De plus, la température de croissance de cette couche EBL est différente de la température de croissance des autres couches de la diode. De plus, lorsque la diode prend la forme d'un nanofil, il n'est pas aisé de trouver des conditions de croissance qui permettent que cette couche EBL vienne recouvrir de manière homogène les flancs du nanofil. Enfin, cette couche EBL doit être dopée p, ce qui nécessite une optimisation du dopage de l'AlGaN.

Une autre solution vise à uniformiser la distribution des trous dans les puits quantiques pour ne pas voir leur injection être limitée aux seuls puits quantiques les plus proches de la région dopée p. Il est pour cela proposé de doper de type p, typiquement en ayant recours à du magnésium, des couches barrière agencées dans la région intrinsèque de telle manière que chaque puits est disposé entre deux couches barrières. Cette solution apparaît difficile à mettre en oeuvre car il faut absolument éviter la diffusion du dopant de type p dans les puits quantiques. Le risque est effectivement d'anéantir l'efficacité de recombinaison radiative dans les puits quantiques, et donc de diminuer fortement la luminescence.

US 2010/0148150 A1 divulgue une diode électroluminescente conforme au préambule de la revendication 1. Le niveau de dopage des couches émissives ne doit pas y dépasser 10¹⁷ à 10¹⁸ donneurs/cm³.

### EXPOSÉ DE L'INVENTION

L'invention vise à proposer une diode électroluminescente présentant un taux de recombinaisons radiatives amélioré et dont une meilleure efficacité d'émission, tout en évitant les problèmes susmentionnés.

Elle propose pour cela une diode électroluminescente à base de GaN, comportant une zone active disposée entre une couche dopée n et une couche dopée p qui forment ensemble une jonction p-n, caractérisée en ce que la zone active comprend au moins une couche émissive dopée n. La zone active comporte une pluralité de couches émissives chacune prise en sandwich entre deux couches barrières, et au moins la couche émissive la plus proche de la couche dopée p est une couche émissive dopée n. L'au moins une couche émissive dopée n est prise en sandwich entre deux couches barrière non intentionnellement dopées. Le niveau de dopage de l'au moins une couche émissive dopée n est supérieur à 10¹⁸ donneurs/cm³.

Certains aspects préférés mais non limitatifs de cette diode électroluminescente sont les suivants :
- le niveau de dopage n de l'au moins une couche émissive est au moins égal à deux fois, et au plus égal à 100 fois, le niveau de dopage non intentionnel des couches barrières ;
- la couche dopée n et la couche dopée p sont des couches de GaN, l'au moins une couche émissive est une couche d'InGaN et les couches barrière sont des couches de GaN.

L'invention s'étend également à un procédé de réalisation d'une telle diode électroluminescente comprenant le dopage n d'au moins une couche émissive de la zone active.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est un schéma représentant un exemple de réalisation d'une LED selon l'invention ;
- la figure 2 représente les efficacités quantiques internes pour l'injection électrique pour différents niveaux de dopage de la couche émissive dopée n ;
- la figure 3 représente la répartition des électrons et des trous dans une diode sans dopage intentionnel des couches émissives et dans une diode avec dopage n des couches émissives selon l'invention ;
- les figures 4A et 4B représentent schématiquement des exemples de réalisation d'une LED sous forme de nanofil.

### EXPOSÉ DÉTAILLÉ DE MODES DE RÉALISATION PARTICULIERS

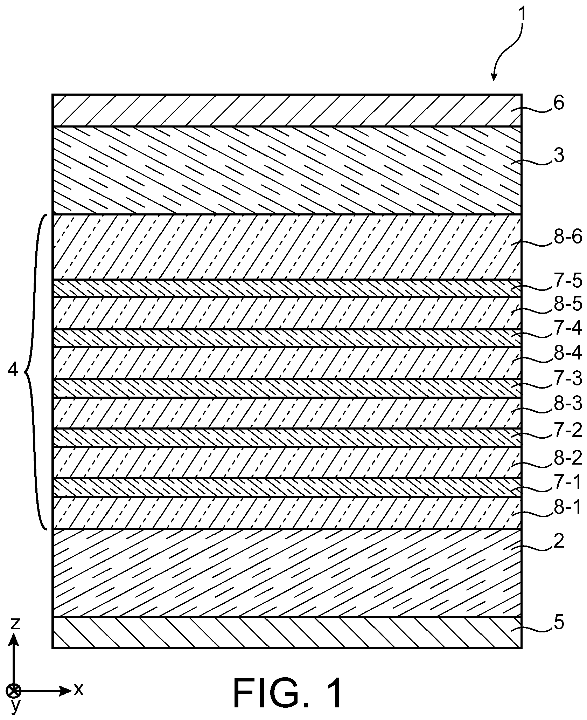

On se réfère tout d'abord à la figure 1 qui représente schématiquement une diode électroluminescente 1, ou LED 100, selon un mode de réalisation particulier.

La LED 1 comporte une jonction p-n formée par une couche dopée n 2, par exemple par ajout de silicium ou de germanium, et une couche dopée p 3, par exemple par ajout de magnésium ou de carbone. Une première électrode métallique 5 est disposée contre la couche dopée n 2 de la jonction p-n et forme une cathode de la LED 1, et une deuxième électrode métallique 6 est disposée contre la couche dopée p 3 de la jonction p-n et forme une anode de la LED 1.

De manière générale, la couche dopée n 2 de la jonction p-n peut avoir une concentration de donneurs comprise entre environ 10¹⁷ et 10²⁰ donneurs/cm³, et la couche dopée p 3 de la jonction p-n peut avoir une concentration d'accepteurs comprise entre environ 10¹⁵ et 10²⁰ accepteurs/cm³.

L'épaisseur (selon l'axe Z sur la figure 1) de la couche dopée n 2 de la jonction p-n est par exemple comprise entre 50 nm et 2 µm, et l'épaisseur de la couche dopée p 3 de la jonction p-n est par exemple comprise entre 5 nm et 2 µm.

La couche dopée n 2 est par exemple une couche d'ln_{Xn}Ga(_{1-Xn})N et la couche dopée p 3 est par exemple une couche d'ln_{Xp}Ga(₁-_{Xp})N , avec Xn et Xp les compositions en indium typiquement comprises entre 0 et 0,25. On prendra dans la suite de la description l'exemple Xn = Xp = 0, les couches dopées 2 et 3 étant alors respectivement en GaN-n et en GaN-p.

La LED 1 comporte, entre les couches dopées 2 et 3, une zone active 4 dans laquelle se produisent des recombinaisons radiatives entrainant une émission lumineuse de la LED 1. La zone active 4 comporte notamment au moins une couche émissive formant un puits quantique prise en sandwich entre deux couches barrière.

On retrouve ainsi dans la zone active 4 m couches émissives 7-1, 7-2, 7-3, 7-4, 7-5, m étant un nombre entier supérieur ou égal à 1 et typiquement inférieur à 50, et m+1 couches barrières 8-1, 8-2, 8-3, 8-4, 8-5, 8-6 telles que chaque couche émissive soit disposée entre deux couches barrières, et donc que la zone active 4 soit formée d'un empilement alterné de couches émissives et de couches barrières avec en particulier une couche barrière 8-1 du côté de la couche dopée n 2 et une couche barrière 8-6 du côté de la couche dopée p 3.

Dans l'exemple de la figure 1, la zone active 4 de la LED 1 comporte cinq couches émissives 7-1, 7-2, 7-3, 7-4, 7-5 formant chacune un puits quantique. L'épaisseur de chacune des couches émissives est comprise entre 0,5 et 10 nm, elle est de 3 nm dans l'exemple étudié. Chaque couche émissive est par exemple une couche d'InGaN, avec une composition en indium pouvant être comprise entre 5 à 30%.

Et la zone active 4 de la LED 1 comporte 6 couches barrières 8-1, 8-2, 8-3, 8-4, 8-5, 8-6 en alternance avec les couches émissives. L'épaisseur de chacune des couches barrière est comprise entre 1 nm et 30 nm. L'épaisseur de la couche barrière 8-6 du côté de la couche dopée p peut être plus importante que celle des autres couches barrière 8-1, 8-2, 8-3, 8-4, 8-5 afin d'éviter que les dopants, généralement du magnésium, contenus dans la couche dopée p 3 ne diffusent jusque dans les puits quantiques. Elle est dans l'exemple étudié de 30 nm, alors que celle des autres couches barrière est de 10 nm. Chaque couche barrière est par exemple une couche de GaN.

Dans un mode de réalisation préférentiel, la LED 1 est dépourvue de couche de blocage d'électrons entre la zone active 4 et la couche dopée p 3 de la jonction p-n. La couche dopée p 3 de la jonction p-n est alors directement en contact avec la zone active 4.

Mais dans un mode de réalisation possible, la LED 1 peut comprendre une couche de blocage d'électrons (non représentée) disposée entre la zone active 4 et la couche dopée p 3 de la jonction p-n, par exemple une couche d'AIGaN.

Dans le cadre de l'invention, au moins une des couches émissives 7-1, 7-2, 7-3, 7-4, 7-5 est dopée n, la ou les autres couches émissives étant non intentionnellement dopées. Cette au moins une couche émissive dopée n est la couche émissive 7-5 la plus proche de la couche dopée p 3. En variante, on peut prévoir que plusieurs couches émissives successives du côté de la couche dopée p 3 soient dopées n, par exemple les trois couches émissives 7-3, 7-4 et 7-5. Ou encore que toutes les couches émissives 7-1, ..., 7-5 soient dopées n, comme c'est le cas dans l'exemple étudié.

Les barrières croissent à des températures plus élevées que les couches émissives ce qui a pour effet de faire diffuser les dopants des couches émissives vers les couches barrières ce qui dégrade la performance de la LED, ceci impactant plus les couches émissives subissant davantage de cycles thermiques (i.e. celles situées du côté de la couche dopée n 2. En optant pour un nombre réduit de couches émissives dopées n du côté de la couche dopée p 3, notamment la seule couche émissive la plus proche de la couche dopée p 3, la performance de la LED n'est donc pas dégradée. Sa fabrication s'en trouve en outre facilitée dans la mesure où pour les couches émissives non intentionnellement dopées, il n'est pas nécessaire d'évacuer des dopants de la chambre avant de croître une couche barrière.

Contrairement à la solution consistant à doper les puits p pour laquelle l'efficacité d'injection des trous dans les puits quantiques proches de la couche dopée n 2 est recherchée, l'invention prend acte de cette faible efficacité d'injection des trous dans les puits quantiques le plus éloignées de la couche dopée p 3, et propose plutôt d'augmenter la densité des électrons dans les puits quantiques où les trous sont effectivement présents, c'est-à-dire dans la ou les couches émissives les plus proches de la couche dopée p 3. Puisque les trous sont essentiellement cantonnés dans ces couches émissives, et que l'on vient grâce au dopage n de l'au moins une couche émissive y augmenter la densité d'électrons, le nombre de recombinaisons radiatives augmente.

Dans une réalisation ne faisant pas partie de l'invention, l'au moins une couche émissive dopée n est prise en sandwich entre deux couches barrière dont au moins la couche barrière agencée du côté de la couche dopée p 3 de la jonction p-n est dopée p. Prenant l'exemple d'un dopage n de la couche émissive 7-5 la plus proche de la couche dopée p 3, la couche barrière 8-6 du côté de couche dopée p 3 est alors dopée p. Bien entendu, on peut également prévoir que tout ou partie des couches barrières soient dopées p par ajout de magnésium ou du carbone. Ainsi dans cette variante de réalisation, on vise également à améliorer l'efficacité d'injection des trous dans les différents puits quantiques, notamment afin qu'ils ne restent pas bloqués dans le ou les puits quantiques les plus proches de la couche dopée p 3 de la jonction p-n.

Dans une variante de cette réalisation, l'au moins une couche barrière dopée p n'est que partiellement dopée p afin d'éviter la diffusion du dopant dans la ou les couches émissives adjacentes. Par partiellement dopée, on entend que seule une région sélectionnée de la couche barrière est dopée p, typiquement une région centrale qui n'est pas au contact d'une couche émissive. Une couche barrière partiellement dopée p peut ainsi se décomposer selon l'axe Z en une sous-couche inférieure non intentionnellement dopée, une sous-couche centrale dopée p, et une sous-couche supérieure non intentionnellement dopée.

Selon l'invention, l'au moins une couche émissive dopée n est prise en sandwich entre deux couches barrière non intentionnellement dopées.

Le niveau de dopage n de l'au moins une couche émissive est alors au moins égal à deux fois, et au plus égal à 100 fois, le niveau de dopage non intentionnel des couches barrières. De préférence, le niveau de dopage n de l'au moins une couche émissive est au moins égal à dix fois, et au plus égal à cinquante fois, le niveau de dopage non intentionnel des couches barrières. Ce niveau de dopage est supérieur à 10¹⁸ donneurs/cm³.

Le niveau de dopage non intentionnel des couches barrières est tel que la concentration en donneurs résiduels est typiquement comprise entre 10¹⁶ donneurs/cm³ et 10¹⁸ donneurs/cm³, de préférence inférieur à 5.10¹⁷ donneurs/cm³, par exemple de 10¹⁷ donneurs/cm³. Et le niveau de dopage n de l'au moins une couche émissive est ainsi au plus égal à 10²⁰ donneurs/cm³.

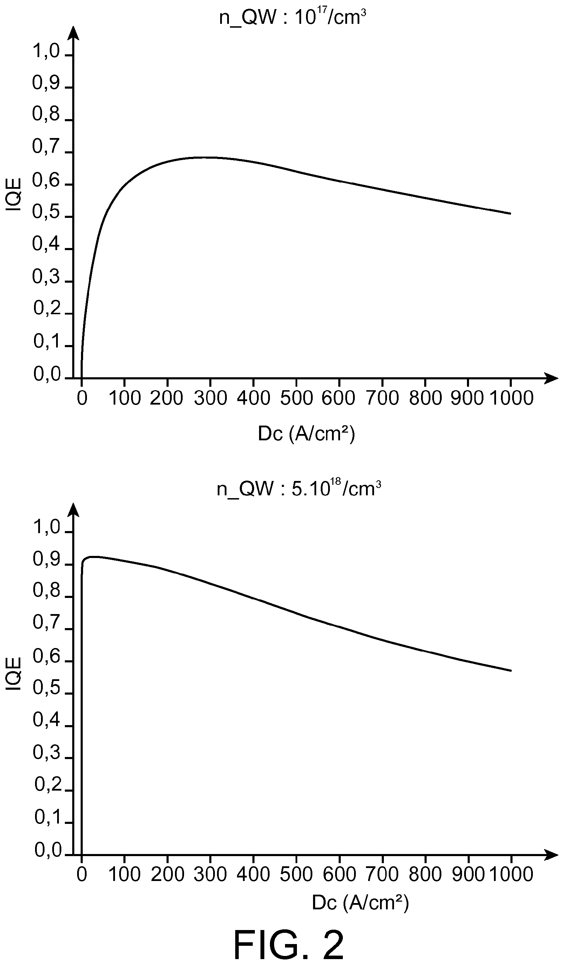

La figure 2 représente les efficacités quantiques internes pour l'émission de photons pour différents niveaux de dopage de la couche émissive dopée n de la LED étudiée dont on rappelle qu'elle comprend cinq couches émissives d'InGaN de 3 nm d'épaisseur prises en sandwich entre des couches barrière de GaN de 10 nm d'épaisseur, sauf pour la plus proche 8-6 de la couche dopée p 3 de la jonction p-n qui est de 30 nm d'épaisseur. La couche dopée n 2 de la jonction p-n présente un dopage de 10¹⁹ donneurs/cm³ et la couche dopée p 3 de la jonction p-n présente un dopage de 10¹⁹ accepteurs/cm³.

Le dopage non intentionnel des couches barrière est de 10¹⁷ donneurs/cm³ et le dopage n (« n_QW ») des couches émissives est soit de 10¹⁷ donneurs/cm³ (en haut sur la figure 2), soit de 5.10¹⁸ donneurs/cm³ (en bas sur la figure 2). On constate que l'efficacité quantique interne IQE, exprimée en fonction de la densité de courant Dc (en A/cm²), augmente lorsque la concentration en dopants n des puits augmente, et ce dès les faibles densités de courant. Le maximum d'efficacité passe ainsi d'environ 70% à plus de 90%.

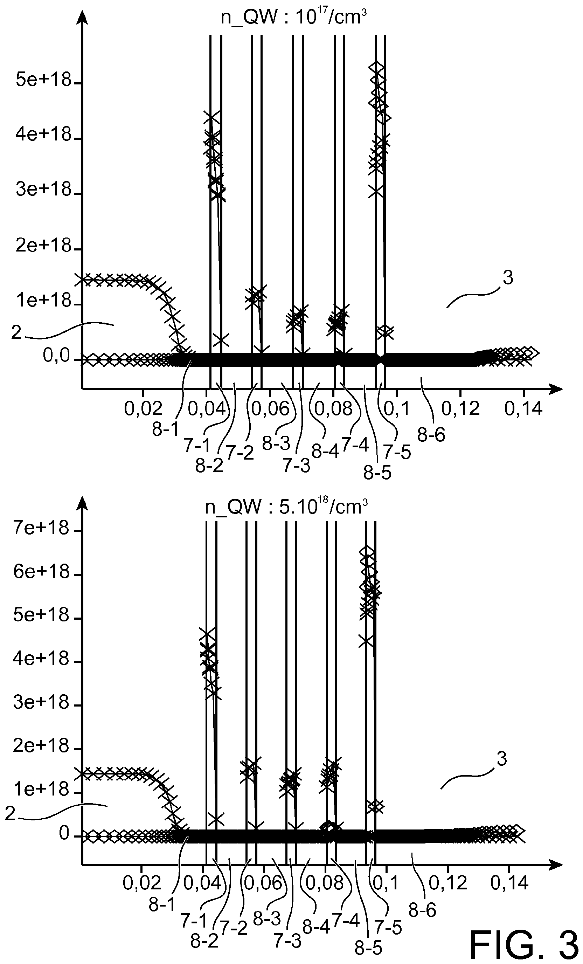

La figure 3 représente la répartition des électrons (représentés par des croix) et des trous (représentés par des losanges) dans une diode selon l'invention avec un dopage n (« n_QW ») des couches émissives qui est soit de 10¹⁷ donneurs/cm⁻³ (en haut sur la figure 3), soit de 5.10¹⁸ donneurs/cm³ (en bas sur la figure 3). On constate que la densité d'électrons est augmentée dans le puits 7-5 le plus proche de la couche dopée p 3 de la jonction p-n lorsque ce puits est dopée n. Les charges sont alors mieux équilibrées dans ce puits 7-5 et le nombre de recombinaisons radiatives est ainsi augmenté.

Une telle LED 1 fonctionne quelle que soit l'orientation de la structure, que ce soit selon le plan c (sous la présence d'un fort champ électrique interne), le plan M, en semi-polaire, etc.

La LED 1 peut être réalisée sous la forme d'une diode planaire comme représenté sur la figure 1, c'est-à-dire sous la forme d'un empilement de couches formées sur un substrat (le substrat n'étant pas représenté sur la figure 1), les faces principales des différentes couches étant disposées parallèlement au plan du substrat (parallèles au plan (X,Y)). Un exemple de réalisation de la LED 1 sous la forme d'une telle diode planaire est le suivant.

On réalise tout d'abord la croissance d'une première couche de GaN d'épaisseur comprise entre 1 et 4 µm sur un substrat saphir, par exemple par MOCVD (« MetalOrganic Chemical Vapour Déposition » en anglais) à une température comprise entre 950 et 1100 °C. Cette croissance est achevée en formant la couche 2 de GaN-n dopé par du silicium, d'épaisseur comprise entre 50 nm et 2 µm.

La zone active 4 est ensuite réalisée en ne dopant pas les barrières mais en dopant les puits quantiques (couches émissives).

La température est tout d'abord abaissée dans la gamme 790-860 °C pour faire croître à une vitesse de croissance d'environ 250 nm/h une couche barrière non intentionnellement dopée de 10 nm d'épaisseur, formant la couche 8-1. La température est ensuite abaissée entre 700 et 800°C pour faire croître une première couche émissive 7-1 dopée à une vitesse de croissance comprise entre 30 et 100 nm/h. Un dopage au silicium est réalisé au cours de la croissance de la couche émissive en utilisant un flux de silane.

Puis ces étapes de croissance de couche barrière et de couche émissive sont réitérées jusqu'à finalisation de la zone active. Il faut environ 100s pour faire croitre une couche émissive, ce qui laisse suffisamment de temps pour doper sélectivement les couches émissives et pas les barrières.

La température est ensuite remontée entre 980°c et 1100°C pour faire croître la couche 3 de GaN-p dopée par du magnésium et d'épaisseur comprise entre 5nm et 1 µm.

La deuxième électrode métallique 6 est ensuite réalisée sous la forme d'une couche de Ni/Au sur la couche dopée p 3, et la première électrode métallique 5 est enfin réalisée sous la forme d'une couche de Ti/Au sur la couche dopée n 2 (après désolidarisation de la couche dopée n 2 avec la première couche de GaN d'épaisseur comprise entre 1 et 4 µm).

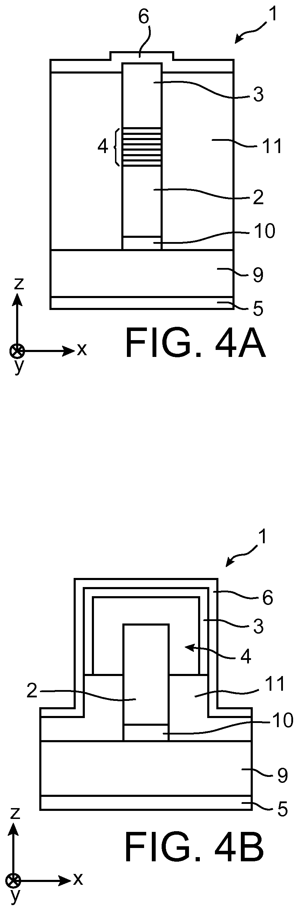

En variante, la LED 1 peut être réalisée sous la forme de nanofils. La figure 4A représente une telle LED 1 réalisée sous la forme de nanofils axiaux, ces nanofils comportant un empilement formé de la première électrode 5, d'un substrat 9 de semi-conducteur (par exemple du gallium) de type n, d'une couche de nucléation 10 permettant la croissance des nanofils, de la couche dopée n 2, de la zone active 4, de la couche dopée p 3, et de la deuxième électrode 6. Un matériau isolant 11 peut entourer au moins une partie de ces nanofils qui s'étendent parallèlement à l'axe Z.

La figure 4B représente une LED 1 réalisée sous la forme de nanofils radiaux, ces nanofils comportant un empilement formé de la première électrode 5, du substrat 9 de semi-conducteur, de la couche de nucléation 10 et de la couche dopée n 2. Des portions isolantes 11 entourent en partie la couche dopée n 2 et la couche de nucléation 10. La zone active 4 est réalisée telle qu'elle entoure au moins une partie de la couche dopée n 2. La couche dopée p 3 est réalisée telle qu'elle entoure la zone active 4. Enfin, la deuxième électrode 6 est réalisée en recouvrant la couche dopée p 3.

En variante des deux exemples de réalisation décrits sur les figures 4A et 4B, la structure de ces nanofils peut être inversée, avec dans ce cas un substrat 9 de semi-conducteur, par exemple de nitrure de gallium, de type p sur lequel est réalisée la couche dopée p 3, puis les autres éléments de la LED 1 dans l'ordre inverse de celui décrit sur les figures 4A et 4B.

L'invention n'est pas limitée à la LED telle que précédemment décrite mais concerne également un procédé de réalisation d'une telle LED, selon lequel la formation de la zone active comprend la réalisation d'au moins une couche émissive dopée n. Selon ce procédé, l'au moins une couche émissive peut être réalisée par croissance à une vitesse de croissance comprise entre 30 et 100 nm/h. Par ailleurs, les couches de la diode électroluminescente peuvent être des couches planaires réalisées par croissance les unes au-dessus des autres, ou des couches réalisées par croissance sous la forme de nanofils radiaux ou axiaux.

## Revendications

1. Diode électroluminescente (1) à base de GaN, comportant une zone active (4) disposée entre une couche dopée n (2) et une couche dopée p (3) qui forment ensemble une jonction p-n, la zone active (4) comportant une pluralité de couches émissives (7-1, 7-2, 7-3, 7-4, 7-5) chacune prise en sandwich entre deux couches barrières (8-1, 8-2, 8-3, 8-4, 8-5, 8-6), dans laquelle au moins la couche émissive (7-5) la plus proche de la couche dopée p (3) est une couche émissive dopée n prise en sandwich entre deux couches barrière non intentionnellement dopées (8-5, 8-6), **caractérisé en ce que** le niveau de dopage de l'au moins une couche émissive dopée n (7-5) est supérieur à 10¹⁸ donneurs/cm³.

2. Diode électroluminescente (1) selon la revendication 1, dans laquelle le niveau de dopage de l'au moins une couche émissive dopée n (7-5) est au moins égal à deux fois, et au plus égal à 100 fois, le niveau de dopage non intentionnel des couches barrières (8-1, 8-2, 8-3, 8-4, 8-5, 8-6).

3. Diode électroluminescente (1) selon la revendication 2, dans laquelle le niveau de dopage de l'au moins une couche émissive dopée n (7-5) est au moins égal à dix fois, et au plus égal à cinquante fois, le niveau de dopage non intentionnel des couches barrières (8-1, 8-2, 8-3, 8-4, 8-5, 8-6).

4. Diode électroluminescente (1) selon l'une des revendications 1 à 3, dans laquelle le niveau de dopage non intentionnel des couches barrières (8-1, 8-2, 8-3, 8-4, 8-5, 8-6) est compris entre 10¹⁶ donneurs/cm³ et 10²⁰ donneurs/cm³,

5. Diode électroluminescente (1) selon l'une des revendications 1 à 4, dans laquelle le niveau de dopage de l'au moins une couche émissive dopée n (7-5) est au plus égal à 10²⁰ donneurs/cm³.

6. Diode électroluminescente selon l'une des revendications 1 à 5, dans laquelle la couche dopée n (2) et la couche dopée p (3) sont des couches de GaN, les couches émissives (7-1, 7-2, 7-3, 7-4, 7-5) sont des couches d'InGaN et les couches barrière (8-1, 8-2, 8-3, 8-4, 8-5, 8-6) sont des couches de GaN.

7. Diode électroluminescente (1) selon l'une des revendications 1 à 6, dépourvue d'une couche de blocage d'électrons entre la zone active (4) et la couche dopée p (3).

8. Diode électroluminescente (1) selon l'une des revendications 1 à 7, dans laquelle la couche barrière la plus proche (8-6) de la couche dopée p (3) présente une épaisseur plus importante que la ou les autres couches barrière (8-1, 8-2, 8-3, 8-4, 8-5).

9. Diode électroluminescente (1) selon l'une des revendications 1 à 8, dans laquelle seule la couche émissive (7-5) la plus proche de la couche dopée p (3) est une couche émissive dopée n, la ou les autres couches émissives étant non intentionnellement dopées.

10. Procédé de réalisation d'une diode électroluminescente (1) comportant une zone active (4) disposée entre une couche dopée n (2) et une couche dopée p (3) qui forment ensemble une jonction p-n, dans lequel la formation de la zone active (4) comprend la réalisation d'au moins une couche émissive dopée n (7-1, 7-2, 7-3, 7-4, 7-5) prise en sandwich entre deux couches barrières (8-1, 8-2, 8-3, 8-4, 8-5, 8-6), la couche émissive (7-5) la plus proche de la couche dopée p (3) étant une couche émissive dopée n prise en sandwich entre deux couches barrière non intentionnellement dopées (8-6), **caractérisé en ce que** le niveau de dopage de l'au moins une couche émissive dopée n (7-5) est supérieur à 10¹⁸ donneurs/cm³.

11. Procédé selon la revendication 10, dans lequel l'au moins une couche émissive (7-5) est réalisée par croissance à une vitesse de croissance comprise entre 30 et 100 nm/h.

12. Procédé selon l'une des revendications 10 et 11, dans lequel les couches de la diode électroluminescente sont des couches planaires réalisées par croissance les unes au-dessus des autres, ou dans lequel les couches de la diode électroluminescente sont réalisées par croissance sous la forme de nanofils radiaux ou axiaux.

13. Procédé selon la revendication 10, dans lequel seule la couche émissive (7-5) la plus proche de la couche dopée p (3) est une couche émissive dopée n, la ou les autres couches émissives étant non intentionnellement dopées.

## Patentansprüche

1. GaN-basierte Leuchtdiode (1), umfassend eine aktive Zone (4), die zwischen einer n-dotierten Schicht (2) und einer p-dotierten Schicht (3) angeordnet ist, die zusammen einen p-n-Übergang bilden, wobei die aktive Zone (4) eine Mehrzahl an Emissionsschichten (7-1, 7-2, 7-3, 7-4, 7-5) umfasst, die jeweils zwischen zwei Barriereschichten (8-1, 8-2, 8-3, 8-4, 8-5, 8-6) sandwichartig angeordnet sind, in der mindestens die der p-dotierten Schicht (3) am nächsten liegende Emissionsschicht (7-5) eine n-dotierte Emissionsschicht ist, die zwischen zwei unbeabsichtigt dotierten Barriereschichten (8-5, 8-6) sandwichartig angeordnet ist, **dadurch gekennzeichnet, dass** der Dotierungsgrad der mindestens einen n-dotierten Emissionsschicht (7-5) mehr als 10¹⁸ Donoren/cm³ beträgt.

2. Leuchtdiode (1) nach Anspruch 1, bei der der Dotierungsgrad der mindestens einen n-dotierten Emissionsschicht (7-5) mindestens gleich zweimal und höchstens gleich 100-mal der unbeabsichtigte Dotierungsgrad der Barriereschichten (8-1, 8-2, 8-3, 8-4, 8-5, 8-6) ist.

3. Leuchtdiode (1) nach Anspruch 2, bei der der Dotierungsgrad der mindestens einen n-dotierten Emissionsschicht (7-5) mindestens gleich zehnmal und höchstens gleich fünfzigmal der unbeabsichtigte Dotierungsgrad der Barriereschichten (8-1, 8-2, 8-3, 8-4, 8-5, 8-6) ist.

4. Leuchtdiode (1) nach einem der Ansprüche 1 bis 3, bei der der unbeabsichtigte Dotierungsgrad der Barriereschichten (8-1, 8-2, 8-3, 8-4, 8-5, 8-6) zwischen 10¹⁶ Donoren/cm³ und 10²⁰ Donoren/cm³ ist.

5. Leuchtdiode (1) nach einem der Ansprüche 1 bis 4, bei der der Dotierungsgrad der mindestens einen n-dotierten Emissionsschicht (7-5) höchstens gleich 10²⁰ Donoren/cm³ ist.

6. Leuchtdiode nach einem der Ansprüche 1 bis 5, bei der die n-dotierte Schicht (2) und die p-dotierte Schicht (3) GaN-Schichten sind, die Emissionsschichten (7-1, 7-2, 7-3, 7-4, 7-5) InGaN-Schichten sind und die Barriereschichten (8-1, 8-2, 8-3, 8-4, 8-5, 8-6) GaN-Schichten sind.

7. Leuchtdiode (1) nach einem der Ansprüche 1 bis 6 ohne eine Elektronenblockierschicht zwischen der aktiven Zone (4) und der p-dotierten Schicht (3).

8. Leuchtdiode (1) nach einem der Ansprüche 1 bis 7, bei der die der p-dotierten Schicht (3) am nächsten liegende Barriereschicht (8-6) eine größere Dicke aufweist als die andere(n) Barriereschicht(en) (8-1, 8-2, 8-3, 8-4, 8-5).

9. Leuchtdiode (1) nach einem der Ansprüche 1 bis 8, bei der nur die der p-dotierten Schicht (3) am nächsten liegende Emissionsschicht (7-5) eine n-dotierte Emissionsschicht ist, wobei die andere(n) Emissionsschicht(en) unbeabsichtigt dotiert ist/sind.

10. Verfahren zur Erzeugung einer Leuchtdiode (1), umfassend eine aktive Zone (4), die zwischen einer n-dotierten Schicht (2) und einer p-dotierten Schicht (3) angeordnet ist, die zusammen einen p-n-Übergang bilden, wobei die Bildung der aktiven Zone (4) die Erzeugung mindestens einer n-dotierten Emissionsschicht (7-1, 7-2, 7-3, 7-4, 7-5) umfasst, die zwischen zwei Barriereschichten (8-1, 8-2, 8-3, 8-4, 8-5, 8-6) sandwichartig angeordnet ist, wobei die der p-dotierten Schicht (3) am nächsten liegende Emissionsschicht (7-5) eine n-dotierte Emissionsschicht ist, die zwischen zwei unbeabsichtigt dotierten Barriereschichten (8-6) sandwichartig angeordnet ist, **dadurch gekennzeichnet, dass** der Dotierungsgrad der mindestens einen n-dotierten Emissionsschicht (7-5) mehr als 10¹⁸ Donoren/cm³ beträgt.

11. Verfahren nach Anspruch 10, bei dem die mindestens eine Emissionsschicht (7-5) durch Wachstum mit einer Wachstumsgeschwindigkeit zwischen 30 und 100 nm/h erzeugt wird.

12. Verfahren nach einem der Ansprüche 10 und 11, bei dem die Schichten der Leuchtdiode planare Schichten sind, die durch Wachstum der einen über den anderen erzeugt werden, oder bei dem die Schichten der Leuchtdiode durch Wachstum in Form radialer oder axialer Nanofasern erzeugt werden.

13. Verfahren nach Anspruch 10, in dem nur die der p-dotierten Schicht (3) am nächsten liegende Emissionsschicht (7-5) eine n-dotierte Emissionsschicht ist, wobei die andere(n) Emissionsschicht(en) unbeabsichtigt dotiert ist/sind.

## Claims

1. Light emitting diode (1) based on GaN, comprising an active zone (4) located between an n-doped layer (2) and a p-doped layer (3) that together form a p-n junction, the active zone (4) comprising a plurality of emissive layers (7-1, 7-2, 7-3, 7-4, 7-5) each sandwiched between two barrier layers (8-1, 8-2, 8-3, 8-4, 8-5, 8-6), in which at least the emissive layer (7-5) closest to the p-doped layer (3) is an n-doped emissive layer sandwiched between two non-intentionally doped barrier layers (8-5, 8-6), **characterized in that** the doping level of the at least one n-doped emissive layer (7-5) is greater than 10¹⁸ donors/cm³.

2. Light emitting diode (1) according to claim 1, in which the doping level of the at least one n-doped emissive layer (7-5) is equal to at least twice and not more than 100 times the non-intentionally doping level of the barrier layers (8-1, 8-2, 8-3, 8-4, 8-5, 8-6).

3. Light emitting diode (1) according to claim 2, in which the doping level of the at least one n-doped emissive layer (7-5) is equal to at least ten times and not more than fifty times the non-intentional doping level of the barrier layers (8-1, 8-2, 8-3, 8-4, 8-5, 8-6).

4. Light emitting diode (1) according to one of claims 1 to 3, in which the non-intentional doping level of the barrier layers (8-1, 8-2, 8-3, 8-4, 8-5, 8-6) is between 10¹⁶ donors/cm³ and 10²⁰ donors/cm³.

5. Light emitting diode (1) according to one of claims 1 to 4, in which the doping level of the at least one n-doped emissive layer (7-5) is not more than 10²⁰ donors/cm³.

6. Light emitting diode according to one of claims 1 to 5, in which the n-doped layer (2) and the p-doped layer (3) are GaN layers, the emissive layers (7-1, 7-2, 7-3, 7-4, 7-5) are InGaN layers and the barrier layers (8-1, 8-2, 8-3, 8-4, 8-5, 8-6) are GaN layers.

7. Light emitting diode (1) according to one of claims 1 to 6, not having an electron blocking layer between the active zone (4) and the p-doped layer (3).

8. Light emitting diode (1) according to one of claims 1 to 7, in which the barrier layer (8-6) closest to the p-doped layer (3) is thicker than the other barrier layers (8-1, 8-2, 8-3, 8-4, 8-5).

9. Light emitting diode (1) according to one of claims 1 to 8, in which only the emissive layer (7-5) closest to the p-doped layer (3) is an n-doped emissive layer, the other emissive layers being non-intentionally doped.

10. Method of making a light emitting diode (1) comprising an active zone (4) located between an n-doped layer (2) and a p-doped layer (3) that together form a p-n junction, in which the formation of the active zone (4) comprises the formation of at least one n-doped emissive layer (7-1, 7-2, 7-3, 7-4, 7-5) sandwiched between two barrier layers (8-1, 8-2, 8-3, 8-4, 8-5, 8-6), the emissive layer (7-5) closest to the p-doped layer (3) being an n-doped emissive layer sandwiched between two non-intentionally doped barrier layers (8-1, 8-2, 8-3, 8-4, 8-5, 8-6), **characterized in that** the doping level of the at least one n-doped emissive layer (7-5) is greater than 10¹⁸ donors/cm³.

11. Method according to claim 10, in which the at least one emissive layer (7-5) is formed by growth at a growth rate between 30 and 100 nm/h.

12. Method according to one of claims 10 and 11, in which the layers of the light emitting diode are planar layers formed by growth above each other, or in which the layers of the light emitting diode are formed by growth in the form of radial or axial nanowires.

13. Method according to claim 10, in which only the emissive layer (7-5) closest to the p-doped layer (3) is an n-doped emissive layer, the other emissive layers being non-intentionally doped.
